# EUROPÄISCHE PATENTANMELDUNG

(11) **EP 1 901 078 A2**
(43) Veröffentlichungstag der Anmeldung: **19.03.2008**
(21) Anmeldenummer: 07017958.5
(22) Anmeldetag: 13.09.2007
(51) Int. Cl.: G01R 11/04, G01R 22/06

(54) **Anschlussvorrichtung für einen Strohmzähler**

(30) Priorität: 14.09.2006 DE 102006043057
(71) Anmelder: Hager Electro GmbH & Co. KG, 66131 Saarbrücken (DE)
(72) Erfinder: Kelaiditis, Konstantin, 66386 St. Ingbert (DE)
(74) Vertreter: Bernhardt, Reinold

(57) **Zusammenfassung**

Die Erfindung betrifft eine Anschlussvorrichtung (1) für einen Stromzähler (2) mit einer den Stromzähler (2) aufnehmenden Tragplatte (5), welche Durchgänge (10) für vom Stromzähler (8) vorstehende Anschlusskontaktstücke (9) aufweist, mit Anschlussleitern (11-17) auf der dem Stromzähler (2) abgewandten Seite der Tragplatte (5) für wenigstens eine Stromphase, welche durch Verschiebung des Stromzählers auf der Tragplatte (5) jeweils mit einem der Anschlusskontaktstücke (9) verbindbar oder davon lösbar sind, und mit einem die Anschlussleiter (11-17) bei Abkopplung des Stromzählers (2) von der Tragplatte (5) kurzschließendem Verbindungsstück (28), das zur Herstellung oder/und Lösung der Kurzschlussverbindung über einen durch die Verschiebung des Stromzählers (2) auf der Tragplatte (5) betätigtes Schieberelement (33,35) bewegbar ist. Erfindungsgemäß ist in der Überbrückungsstellung das Verbindungsstück (28) durch das Schieberelement (33,35) oder/und eine elastische Rückstellkraft des Verbindungsstücks (28) im Presskontakt mit wenigstens einem der Anschlussleiter (11-17) gehalten. Vorzugsweise ist die durch das Schieberelement ausgeübte Presskraft quer zur Verschiebungsrichtung des Stromzählers (2) gerichtet.

## Beschreibung

Die Erfindung betrifft eine Anschlussvorrichtung für einen Stromzähler, mit einer den Stromzähler aufnehmenden Tragplatte, welche Durchgänge für vom Stromzählergehäuse vorstehende Anschlusskontaktstücke aufweist, mit Anschlussleitern auf der dem Stromzähler abgewandten Seite der Tragplatte für wenigstens eine Stromphase, die durch Verschiebung des Stromzählers auf der Tragplatte jeweils mit einem der Anschlusskontaktstücke verbindbar oder davon lösbar sind, und mit einem die Anschlussleiter bei Abkopplung des Stromzählers von der Tragplatte überbrückenden Verbindungsstück, das zur Herstellung oder/und Lösung der Überbrückungsverbindung über ein durch die Verschiebung des Stromzählers auf der Tragplatte betätigtes Schieberelement bewegbar ist.

Aus der DE 10 2004 025 605 A1 ist eine solche Anschlussvorrichtung mit einem Verbindungsstück in Form eines Kupferblechstreifens bekannt, welcher im überbrückten Zustand der Vorrichtung in Klemmschenkel aufweisende Kontaktgabeln der Anschlussleiter eingreift. Als Schieberelement dient eine zwischen der Tragplatte und den Anschlussleitern angeordnete Schieberplatte, von der Mitnehmernasen vorstehen, welche in eine Randausnehmung in dem Verbindungsstück eingreifen. Zur Lösung der Überbrückung wird das Verbindungsstück über das Schieberelement parallel zum Stromzähler verschoben, wobei sich das Verbindungsstück aus der Klemmverbindung mit einer der Kontaktgabeln löst.

Der vorliegenden Erfindung liegt die Aufgabe zugrunde, eine neue Anschlussvorrichtung der eingangs erwähnten Art zu schaffen, welche gegenüber der bekannten Vorrichtung konstruktiv vereinfacht ist.

Die diese Aufgabe lösende Vorrichtung nach der Erfindung ist dadurch gekennzeichnet, dass in der Überbrückungsstellung das Verbindungsstück durch das Schieberelement oder/und durch eine elastische Rückstellkraft des Verbindungsstücks im Presskontakt mit wenigstens einem der beiden Anschlussleiter gehalten ist.

Gemäß dieser Erfindungslösung kommt es zu einer konstruktiven Vereinfachung, indem das Verbindungsstück nicht in Klemmverbindung zwischen zwei Schenkeln einer Kontaktgabel gehalten, sondern nur gegen den betreffenden Anschlussleiter angepresst wird.

Vorzugsweise wirkt die Presskraft quer zur Verschiebungsrichtung des Stromzählers.

Das Schieberelement kann gegen das durch das Schieberelement bewegte Verbindungsstück gleitend oder rollend unter Bewegung des Verbindungsstücks quer zur Verschiebungsrichtung des Stromzählers oder/und unter Drehung des Verbindungsstücks anliegen.

Vorzugsweise ist das Schieberelement in der Überbrückungsstellung durch eine Haltenase abgestützt, die eine zusätzliche Haltekraft in einer zur Tragplattenebene parallelen Richtung erzeugt.

Das Verbindungsstück kann ständig mit einem der zu überbrückenden Anschlussleiter verbunden sein, wobei vorzugsweise eine einstückige Verbindung besteht und das Verbindungsstück als längliche, durch das Schieberelement abbiegbare, gegen den anderen Anschlussleiter anlegbare Zunge ausgebildet ist.

Das Verbindungsstück kann somit als einarmiger Hebel ausgebildet sein mit einem Kontaktabschnitt, der zwischen dem Drehpunkt und einem Betätigungsabschnitt liegt, an dem das Schieberelement angreift.

Alternativ wäre ein zweiarmiger Hebel denkbar, dessen Arme zum Überbrücken jeweils in Kontakt mit einem der Anschlussleiter gebracht werden.

In einer bevorzugten Ausführungsform der Erfindung umfassen die Anschlussleiter Kontaktgabeln, welche Klemmschenkel aufweisen, zwischen denen die Anschlusskontaktstücke des Stromzählers einklemmbar sind. Diese seitlich ausgewölbten Klemmschenkel liegen dem jeweils benachbarten Anschlussleiter am nächsten, so dass der Kontaktabschnitt des Verbindungsstücks zweckmäßig gegen den Klemmschenkel der betreffenden Kontaktgabel anliegt. In diesem Fall sind nur geringe Schwenkwinkel zur Herstellung der Überbrückungsverbindung erforderlich.

Vorzugsweise ist das Schieberelement durch eine Schieberplatte mit vorstehenden Nasen ausgebildet. In der Schieberplatte ist eine Ausnehmung vorgesehen, in die eine in der Ebene der Schieberplatte verschwenkbare Nase mit einem Hakenelement hineinragt, das eine Verschiebung der Schieberplatte durch den Stromzähler verhindert, solange dieser nicht ordnungsgemäß unter vollständiger Abdeckung aller Öffnungen und Abschirmung spannungsführender Teile auf die Tragplatte aufgesetzt ist.

Vorteilhaft ermöglicht die vorliegende Erfindung kürzere Stromwege. Entsprechend besteht Spielraum für eine Erhöhung der maximalen Betriebsstromstärke, z.B. auf 100A.

Die Erfindung wird nachfolgend anhand von Ausführungsbeispielen und der beiliegenden, sich auf diese Ausführungsbeispiele beziehenden Zeichnungen weiter erläutert. Es zeigen:
- Fig. 1: eine erfindungsgemäße Anschlussvorrichtung in einer Draufsicht,
- Fig. 2: einen an die Anschlussvorrichtung von Fig. 1 anzuschließenden elektronischen Stromzähler in perspektivischer Ansicht,
- Fig. 3: eine Draufsicht auf die Anschlussvorrichtung von Fig. 1 bei abgenommener Zählertragplatte und abgenommener Schieberplatte,
- Fig. 4: eine Draufsicht auf die Anschlussvorrichtung von Fig. 1 bei abgenommener Zählertragplatte,
- Fig. 5: die in Fig. 4 sichtbare Schieberplatte in einer perspektivischen Ansicht von unten,
- Fig. 6: einen Teil eines in der Vorrichtung von Fig. 1 verwendeten Anschlussleiterstücks in einer Draufsicht,
- Fig. 7: das Anschlussleiterstück von Fig. 6 in einer Seitenansicht,
- Fig. 8: eine perspektivische Ansicht eines in der Vorrichtung von Fig. 1 verwendeten Anschlussleiterstücks,
- Fig. 9: eine die Wirkungsweise der Vorrichtung gemäß Fig. 1 bis 8 erläuternde Darstellung, und
- Fig. 10 bis 21: Teile von Anschlussvorrichtungen gemäß weiteren Ausführungsbeispielen für die vorliegende Erfindung.

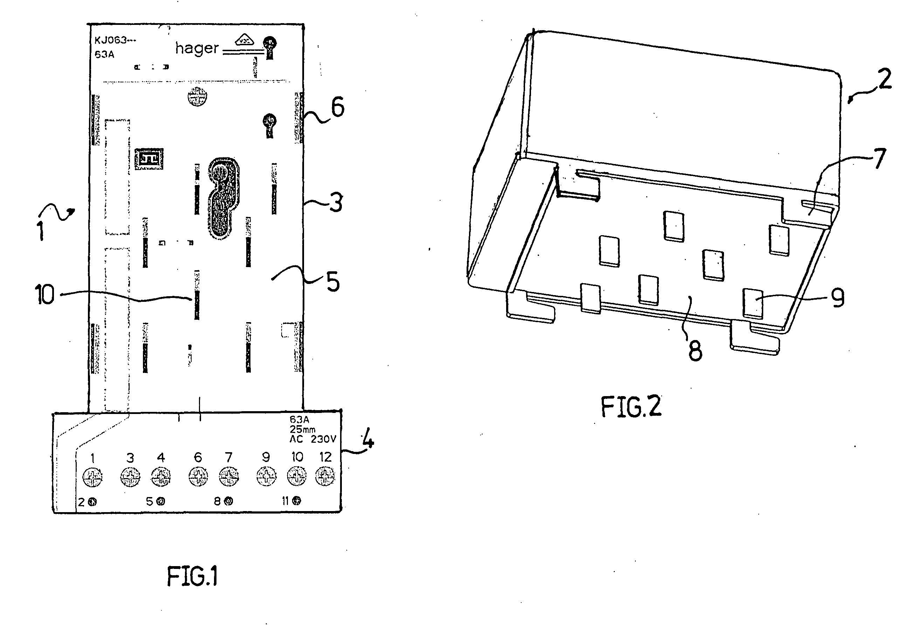

Eine in Fig. 1 dargestellte Anschlussvorrichtung 1 für einen in Fig. 2 gezeigten elektronischen Stromzähler 2 weist einen Aufnahmeabschnitt 3 für den Stromzähler sowie einen Abschnitt 4 auf, welcher eine Anschlussleiste bildet. Die Anschlussvorrichtung kann am Zählerkreuz eines herkömmlichen, der Aufnahme elektromechanischer Stromzähler dienenden Zählerplatzes montiert werden.

An einander gegenüberliegenden Rändern einer den Stromzähler 2 aufnehmenden Zählertragplatte 5 sind jeweils zwei Öffnungen 6 gebildet, in welche beim Aufsetzen des Stromzählers 2 auf die Zählertragplatte 5 an dem Stromzähler 2 angebrachte Hakenelemente 7 eintauchen. Von einer der Anschlussvorrichtung 1 zugewandten Bodenwand 8 des Stromzählergehäuses stehen insgesamt sieben plattenförmige Anschlusskontaktstücke 9 vor, welche beim Aufsetzen des Stromzählers 2 auf die Zählertragplatte 5 in entsprechend angeordnete Langlochdurchgänge 10 in der Zählertragplatte eingreifen.

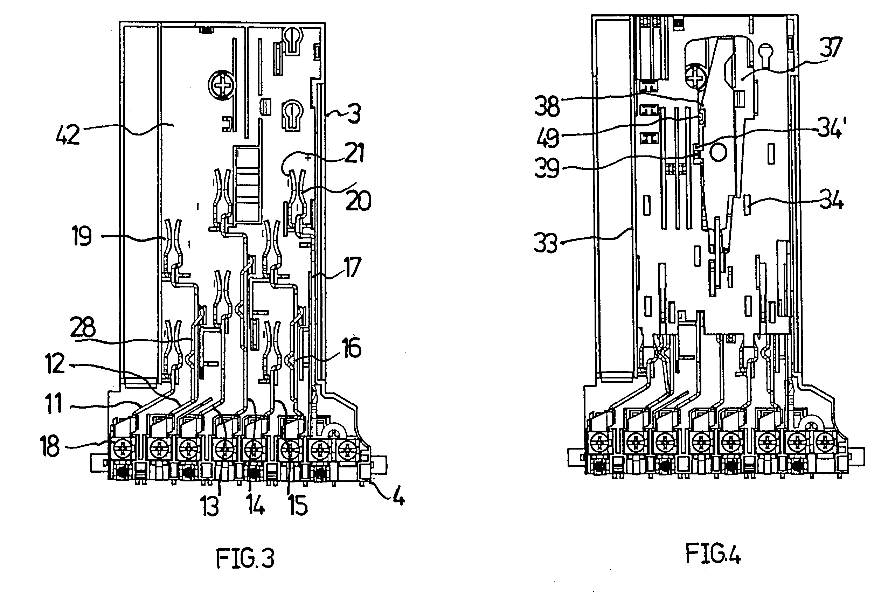

Wie aus Fig. 3 hervorgeht, sind innerhalb des Aufnahmeabschnitts 3 an dessen Bodenwand 42 festgelegte Anschlussleiterstücke 11 bis 17 für drei Stromphasen und den Neutralleiter angeordnet, welche jeweils zu einem Klemmanschlusselement 18 in dem Anschlussleistenabschnitt 4 geführt sind.

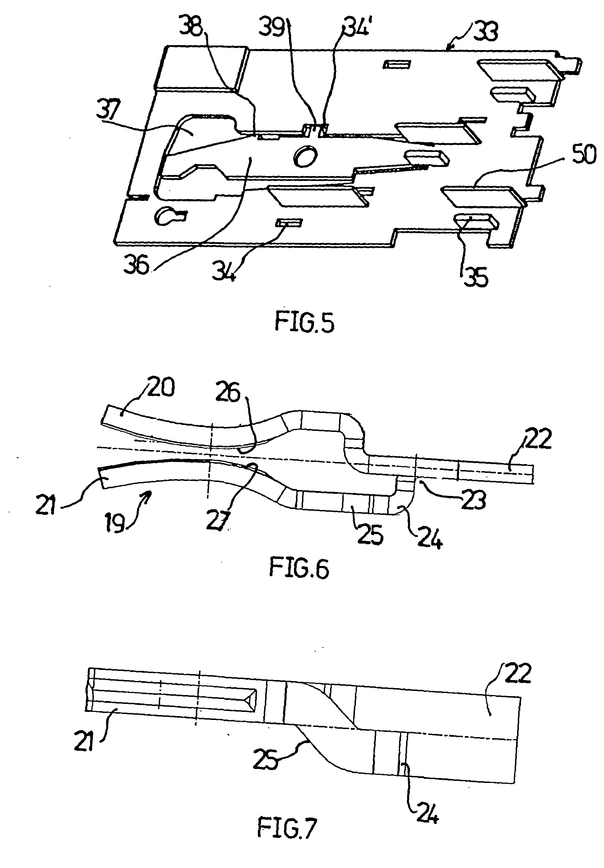

Wie Fig. 3 ferner erkennen lässt, weist jedes der Anschlussleiterstücke 11 bis 17 eine in Fig. 6 und 7 gesondert dargestellte Kontaktgabel 19 mit Klemmschenkeln 20 und 21 auf. Die Klemmschenkel sind durch einen Längseinschnitt in einen Kupferblechstreifen 22 gebildet, wobei der Klemmschenkel 21 bei 23 und 24 abgewinkelt und in einem Abschnitt 25 unter Parallelverschiebung von Längsachsenabschnitten des Schenkels verformt ist, so dass sich die freien Enden der Schenkel 20 und 21 gegenüberliegen. Durch Einprägung sind in den Schenkeln 20 und 21 einander gegenüberliegende Kontaktkämme 26 und 27 zur Erhöhung der Flachenpressung gebildet.

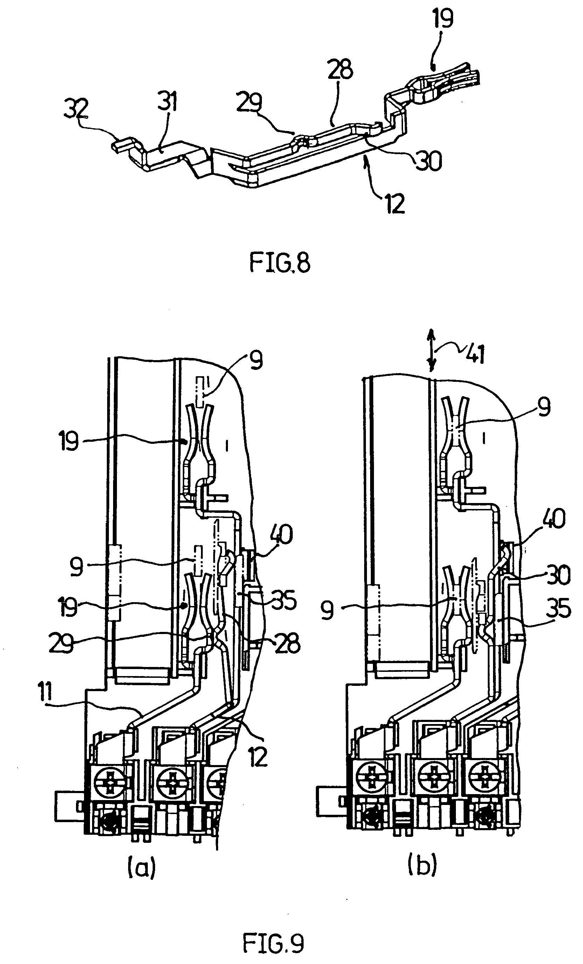

Die Leiterstücke 12, 14 und 16, von denen das Leiterstück 12 gesondert in Fig. 8 dargestellt ist, weisen jeweils eine abbiegbare, ein Verbindungsstück bildende Zunge 28 mit einem in Richtung zum benachbarten Leiterstück der gleichen Stromphase vorspringenden Kontaktabschnitt 29 und einem abgewinkelten Betätigungsabschnitt 30 auf.

Ein Endabschnitt 31 des Leiterstücks 12 dient der Einklemmung in dem Klemmanschlusselement 18, wobei eine vorstehende Nase 32 des Endabschnitts 31 als Kontaktelement zur Verbindung mit einer Leiteranschlussklemme am Zählerplatz dienen kann.

In Fig. 4 und 5 ist eine zwischen den Anschlussleiterstücken 11 bis 17 und der Zählertragplatte 5 angeordnete Schieberplatte 33 gezeigt. Die Schieberplatte 33 weist Durchgangsöffnungen 34 auf, deren Öffnungsquerschnitt dem Querschnitt der von der Bodenwand 8 des Stromzählers 2 vorstehenden Kontaktstücke 9 entspricht. Von der dem Stromzähler 2 abgewandten Seite der Schieberplatte 33 stehen ferner drei Nasen 35 sowie drei dazu parallele Stege 50 vor.

Eine längliche, schwenkbewegliche Zunge 36, die in eine Ausnehmung 37 in der Schieberplatte 33 hineinragt, weist ein Hakenelement 38 auf. Von der Zunge steht eine Nase 39 seitlich in eine halboffene Öffnung 34' hinein vor. Der Querschnitt der Öffnung 34' entspricht dem Querschnitt der Öffnungen 34.

Unter Bezugnahme auf Fig. 9 wird nun die Funktionsweise der anhand der Fig. 1 bis 8 beschriebenen Anschlussvorrichtung erläutert.

Beim Aufsetzen des Stromzählers 2 auf die Anschlussvorrichtung 1 tauchen die Hakenelemente 7 in die Öffnungen 6 und die Anschlusskontaktstücke 9 des Stromzählers 2 in die Langlochdurchgänge 10 der Zählertragplatte 5 ein. Die Anschlusskontaktstücke 9 werden auch durch die Öffnungen 34 der Schieberplatte 33 hindurchgeführt.

Bei ordnungsgemäßem Aufsetzen des Stromzählers 2 auf die Zählertragplatte 5 verschiebt das in die Öffnung 34' eingreifende Kontaktstück 9 die Nase 39 und verschwenkt so die Zunge 36, so dass sich das Hakenelement 39 aus der Verhakung mit einem an der Bodenwand 42 des Aufnahmeabschnitts 3 angebrachten Gegenstück 49 löst. Der Stromzähler 2 kann nun in Längsrichtung der Langlochdurchgänge 10 verschoben werden, wobei die in die Öffnungen 34 eingreifenden Anschlusskontaktstücke 9 die Schieberplatte 33 mitnehmen.

Die vorangehend beschriebene Lösung zur Sicherung des Stromzählers gegen Verschiebung bei unsachgemäßem, geneigtem Aufsetzen des Stromzählers auf die Tragplatte, die ein mit der Schieberplatte verbundenes, durch richtiges Aufsetzen des Stromzählers auf die Tragplatte aus einer Verhakung lösbares Element 36 vorsieht, lässt sich in einer Anschlussvorrichtung gemäß Oberbegriff des Anspruchs 1 auch unabhängig von dem im kennzeichnenden Teil des Anspruchs 1 angegebenen Merkmalen verwenden.

Vor der Verschiebung des Stromzählers befinden sich die Kontaktstücke 9 in einer Position vor den Kontaktgabeln 10, wie dies in Fig. 9a am Beispiel der Anschlussleiterstücke 11 und 12 gezeigt ist. In dieser Stellung des Stromzählers, sind die einstückig mit den Anschlussleiterstücken verbundenen Zungen 28 durch die Nasen 35 der Schieberplatte 33 abgebogen, so dass der Kontaktabschnitt 29 der Zungen 28 im elektrischen Kontakt mit dem jeweils anderen Leiterstück der gleichen Stromphase steht. Die Nasen 35 liegen jeweils ferner gegen eine von der Bodenwand 42 des Aufnahmeabschnitts 3 vorstehende Haltenase 40 an, welche die Klemmkraft verstärkt, mit welcher die Zunge 28 gegen das andere Leiterstück drückt.

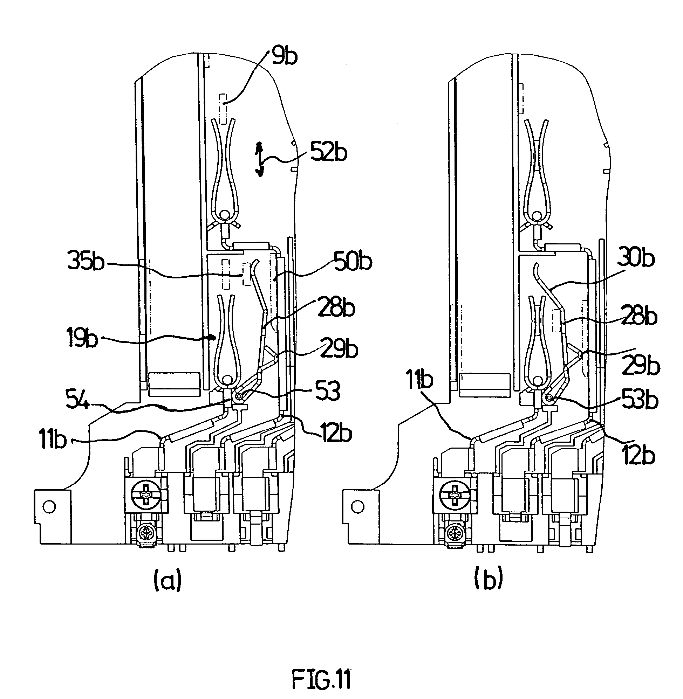

Zum mechanischen und elektrischen Anschließen des Stromzählers 2 an die Vorrichtung 1 wird der Stromzähler 2 in Längsrichtung der Langlochdurchgänge 10 auf der Zählertragplatte 5 verschoben, so dass die Kontaktstücke 9 der betreffenden Stromphasen jeweils in die in Fig. 11 b gezeigte Klemmposition in den Kontaktgabeln 19 gelangen. Die vorstehende Nase 35 gibt den Betätigungsabschnitt 30 der elastisch abgebogenen Zunge 28 frei, so dass der elektrische Kontakt zwischen den Leiterstücken der drei Stromphasen durch Rückfederung der Nasen 28 aufgehoben wird. Für eine sichere elektrische Entkopplung sorgen die Stege 50, die sich vor die Kontaktabschnitte 29 schieben.

Bei Entkopplung des Stromzählers von der Anschlussvorrichtung erfolgt eine Verschiebung in umgekehrter Richtung. Die Nasen 35 schlagen gleitend gegen den schräg zur Verschiebungsrichtung der Nase 35 verlaufenden Betätigungsabschnitt 30 an und sorgen wieder für eine Verschwenkung der Zunge 28. In der Position, in welcher der Stromzähler 2 senkrecht von der Tragplatte 5 abgehoben werden kann, ist der Kontakt zwischen den Leiterstücken jeder Stromphase wieder hergestellt.

Bei entkoppeltem Zähler lässt sich die Schieberplatte so weit in Längsrichtung der Langlochdurchgänge 10 verschieben, dass sämtliche Öffnungen in der Zählertragplatte 5 von innen verdeckt sind. Die Schieberplatte kann in dieser Stellung plombiert werden.

In den nachfolgenden Figuren sind gleiche oder gleichwirkende Teile mit derselben Bezugszahl wie in den vorangehenden Figuren bezeichnet, wobei der betreffenden Bezugszahl der Buchstabe a, b usw. beigefügt ist.

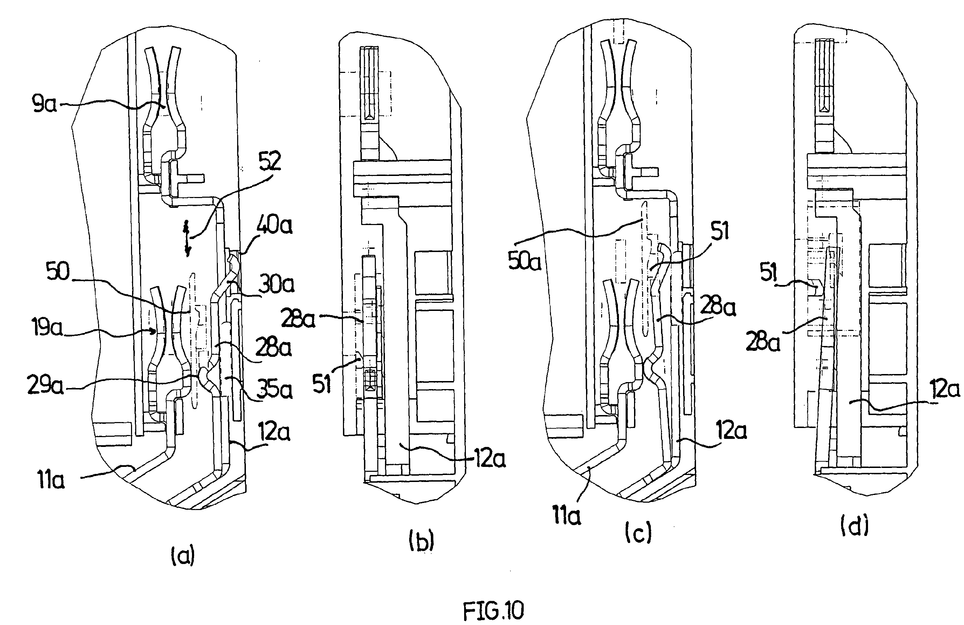

Bei einem in Fig. 10 gezeigten Ausführungsbeispiel ist eine Zunge 28a, die ein Verbindungsstück zur Überbrückung von Anschlussleiterstücken 11a und 12a bildet, nicht nur parallel durch eine Nase 35a sondern auch senkrecht zur Ebene der Zählertragplatte verschiebbar. Zur senkrechten Verschiebung dient eine Rampe 51, welche an einem von einer Schieberplatte vorstehenden Steg 50a gebildet ist.

Fig. 10a und Fig. 10b zeigen die Zunge 28a in ihrer Position bei angeschlossenem Stromzähler. Ein Kontaktabschnitt 29a der Zunge 28a ist durch den isolierenden Steg 50 von dem Leiterstück 11a getrennt.

Bei der Abkopplung des Stromzählers von der Tragplatte verschieben sich die Nase 35a und der Steg 50 gemäß Pfeil 52, wobei die Nase 35a die Zunge 28a mit ihrem Kontaktabschnitt 29a in Kontakt mit dem Anschlussleiterstück 11a bringt. Sobald während dieser Verschiebung der Kontaktabschnitt 29a gegen das Anschlussleiterstück 11a anliegt, wird die Rampe 51 wirksam, welche dafür sorgt, dass die Zunge 28a in einer Richtung senkrecht zur Zählertragplatte verschwenkt wird. Durch diese Verschwenkung kommt es an der Kontaktstelle zwischen der Zunge 28a und dem Anschlussleiterstück 11a zu Reibung, welche die Bildung eines sicheren elektrischen Kontakts fördert.

Bei der Rückverschiebung des Stromzählers in die Betriebsposition gelangt die Zunge 28a wieder in ihre Ausgangsstellung, wobei dieser Vorgang durch eine weitere, mit der Schieberplatte oder dem Boden des Aufnahmeabschnitts verbundene Rampe (nicht gezeigt) unterstützt werden kann. Der Steg 50a sichert die Aufhebung des Überbrückungskontakts.

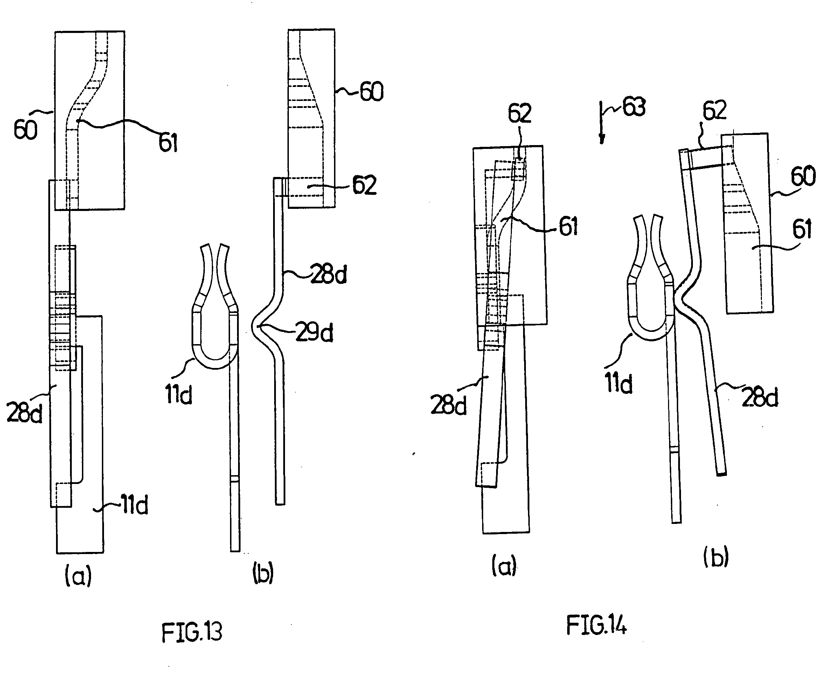

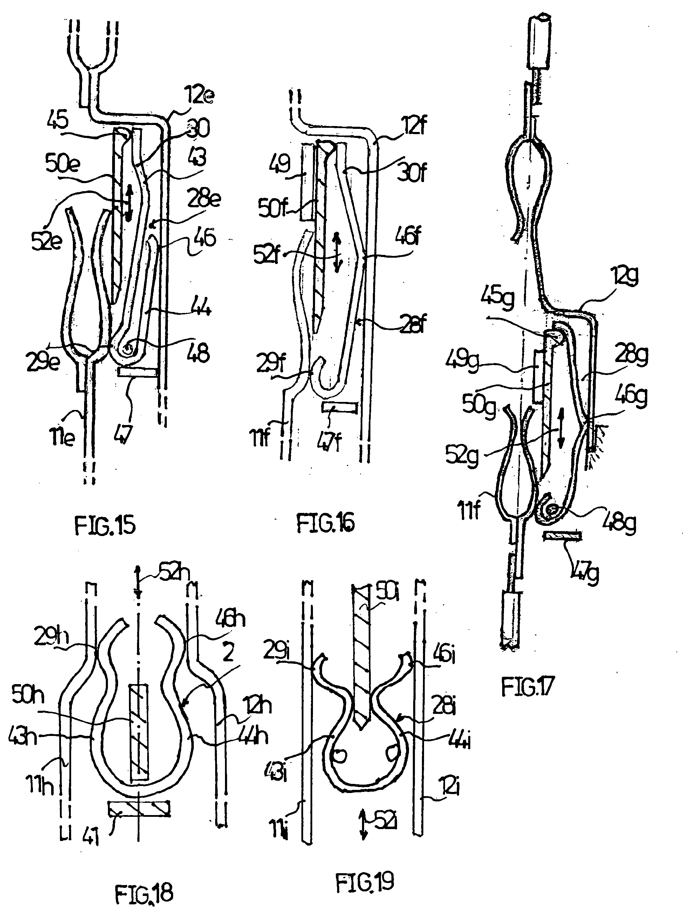

In einer alternativen Ausführungsform könnte die Zunge an ihrem Ende zur Schieberplatte hin abgewinkelt und in einer in der Schieberplatte gebildeten Nutenbahn geführt sein. Eine weitere Alternative ist weiter unten anhand von Fig. 13 und 14 beschrieben.

Bei dem Ausführungsbeispiel von Fig. 11 ist zur Überbrückung von Anschlussleiterstücken 11b und 12b ein um eine Achse 53 drehbares Verbindungsstück 28b mit einem Kontaktabschnitt 29b und einem Betätigungsabschnitt 30b vorgesehen.

Fig. 11a zeigt das Verbindungsstück in der Drehposition bei abgekoppeltem Stromzähler, in welchem es bei 54 gegen das Anschlussleiterstück 11b und mit seinem Kontaktabschnitt 29b gegen das Leiterstück 12b anliegt. Bei Ankopplung des Stromzählers verschieben sich mit einer Schieberplatte verbundene Nasen 35b und damit verbundene Stege 50b gemäß Pfeil 52b. Der Betätigungsabschnitt 30b wird dadurch freigegeben und der Steg 50b trennt den Kontaktabschnitt 29b von dem Anschlussleiterstück 12b. In der in Fig. 11b gezeigten Stellung des Verbindungsstücks 28b ist die Überbrückung aufgehoben.
Bei Verschiebung in umgekehrter Richtung, d.h. beim Abkoppeln des Stromzählers verdreht die gegen den Betätigungsabschnitt 30b anliegende Nase 35b das Verbindungsstück 28b in umgekehrter Richtung.

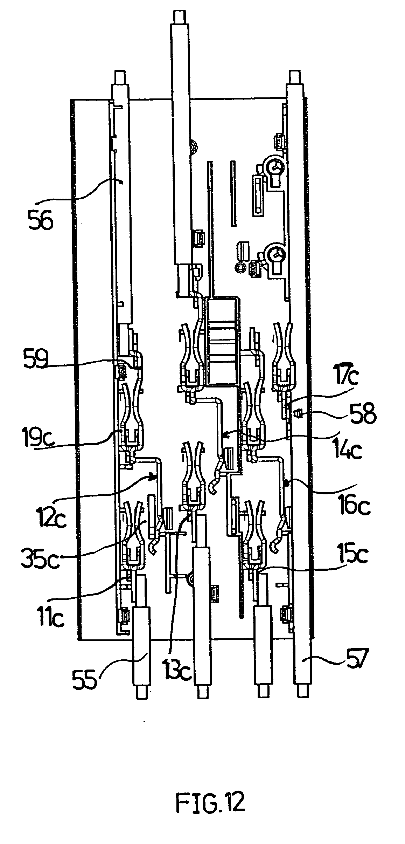

Fig. 12 zeigt Teile einer weiteren Zähleranschlussvorrichtung, wobei diese Teile hinter einer Durchgänge für Anschlusskontaktstücke eines Stromzählers aufweisenden Zählertragplatte (nicht gezeigt) angeordnet sind.

Anschlussleiterstücke 11c, 13c und 15c sind jeweils mit einem Kabel 55 verschweißt, welches in einen unteren Anschlussraum führt. Mit Leiterstücken 12c, 14c und 16c verschweißte Kabel 56 führen in einen oberen Anschlussraum. Ein Anschlussleiterstück 17c ist mit einem Neutralleiterkabel 57 verbunden, welches vom unteren Anschlussraum in den oberen Anschlussraum durchgehend verlegt ist. Die Verbindung zwischen dem Leiterstück 17c und dem Neutralleiterkabel 57 ist durch eine Lasche 58 hergestellt, welche durch die Litzen des Neutralleiterkabels 57 hindurchgesteckt und am Ende abgebogen ist.

Wie Fig. 12 erkennen lässt, weist jedes der Leiterstücke 11c bis 17c eine Kontaktgabel 19c auf, wobei einer der Schenkel der Kontaktgabeln 19c der Leiterstücke 12c, 14c und 16c jeweils mit einer Verlängerung 59 versehen ist, welche die Verbindung zu dem betreffenden Kabel 56 herstellt. Am anderen Ende der Kontaktgabeln 19c dieser Leiterstücke ist jeweils eine Zunge 28c gebildet, welche über eine Nase 35c, wie oben beschrieben, abgebogen werden kann, um eine Überbrückung zum jeweiligen Anschlussleiterstück 11c, 13c bzw. 15c der gleichen Phase herzustellen.

Es wird nun auf Fig. 13 und 14 Bezug genommen. Eine elastisch abbiegbare Zunge 28d, die mit einem im übrigen nicht gezeigten Anschlusskontaktstück verbunden ist, und einen Abschnitt 29d zur Kontaktierung eines weiteren Leiteranschlussstücks 11d aufweist, ist an ihrem Ende mit einer seitlich vorstehenden Nase 62 versehen, die in eine Führungsbahn 61 in einem Block 60 eingreift. Der Block 60 steht von einer zur Papierebene parallelen Schieberplatte vor (nicht gezeigt). Bei Verschiebung des Blocks 60 mit der Schieberplatte gemäß Pfeil 63 kommt es zur Verschwenkung der Zunge 28d sowohl in einer zur Schieberplatte parallelen Ebene (Fig. 14b) als auch in einer dazu senkrechten Ebene (Fig. 14a).

Die Fig. 15 bis 19 zeigen Ausführungsbeispiele mit Verbindungsstücken 28e bis 28i, die von beiden miteinander zu verbindenden Leiterstücken 11e bis 11i und 12e bis 12i getrennt sind.

Ein in Fig. 15 dargestelltes, aus einem Blechstreifen gebogenes Verbindungsstück 28e weist aufeinander zugebogene Schenkel 43 und 44 auf, wobei an einer Biegestelle ein Kontaktabschnitt 29e zur Verbindung mit dem Anschlussleiterstück 11 e gebildet ist. Ein mit einer (nicht gezeigten) Schieberplatte verbundener Steg 50e lässt sich zusammen mit der Schieberplatte gemäß Doppelpfeil 52e hin und her verschieben. Eine mit dem Steg 50e verbundene Nase 45 wirkt auf einen Befestigungsabschnitt 30e des Schenkels 43.

In der in Fig. 15 gezeigten Stellung sind die Anschlussleiterstücke 11 e und 12e durch das fehlende Verbindungsstück 28e überbrückt, wobei der Schenkel 44 einen weiteren Kontaktabschnitt 46 zur elektrischen Verbindung mit dem Anschlussleiterstück 12e bildet.

Bei Anschluss eines Stromzählers wird die Schieberplatte und damit der Steg 50e so verschoben, dass die Nase 45 den Schenkel 43 des Verbindungsstück 28e freigibt und der Steg sich an dem Anschlusskontaktabschnitt 29 unter Aufhebung der elektrischen Verbindung zwischen das Anschlussleiterstück 11e und das Verbindungsstück 28e schiebt. Ein mit einer (nicht gezeigten) Bodenwand der Anschlussvorrichtung verbundener Anschlag 47 hält das Verbindungsstück 28e etwa in seiner Position. Bei Rückverschiebung des Stegs 50e in die in Fig. 15 gezeigte Stellung wird das Verbindungsstück 28e durch einen mit der Bodenplatte verbundenen Stift 48 gehalten.

Bei dem Ausführungsbeispiel von Fig. 16 besteht ein Verbindungsstück 28f aus nur einem, unter Bildung eines Kontaktabschnitts 46f leicht gebogenen Schenkel. In der in Fig. 16 gezeigten Überbrückungsstellung des Verbindungsstücks 28f ist ein mit einer Schieberplatte verbundener Steg 50f durch einen mit einer Bodenplatte verbundenen Steg 49 seitlich abgestützt.

Ein in Fig. 17 gezeigtes Ausführungsbeispiel unterscheidet sich von dem vorangehenden Ausführungsbeispiel dadurch, dass ein Verbindungsstück 28g an einem Ende eine Abbiegung 41 aufweist, an welcher eine Nase 45g eines Steges 50g angreift, so dass das Verbindungsstück 28g durch den Steg 50g in Richtung eines Doppelpfeils 52g verschiebbar ist. In dem gezeigten Ausführungsbeispiel gibt bei dieser Verschiebung ein mit einer Bodenplatte verbundener Stift 48g etwas nach. Durch die Verschiebung kommt es zu einer den elektrischen Kontakt sichernden Reibung in einem Kontaktabschnitt 46g.

Während bei den vorangehenden Ausführungsbeispielen das Verbindungsstück durch den Schieber bzw. den damit verbundenen Steg im Presskontakt mit beiden Anschlussleiterstücken gehalten wird, sorgt bei dem Ausführungsbeispiel von Fig. 18 für einen solchen Presskontakt bei 29h und 46h allein eine elastische Verformung des Verbindungsstücks 28h. In der in Fig. 18 gezeigten Überbrückungsstellung sind Schenkel 43h und 44h zusammengedrückt, so dass sie gegen Anschlussleiterstücke 11h und 12h anliegen. Beim Anschluss eines Stromzählers wird das Verbindungsstück 28h mit Hilfe eines Steges 50h gemäß Pfeil 52h verschoben, wobei sich die Schenkel 43h und 44h von den Anschlussleiterstücken abheben. Zur Rückführung des Verbindungsstücks 28h in die Überbrückungsstellung sorgt ein mit einer Schieberplatte verbundener Mitnehmer 41.

Bei dem Ausführungsbeispiel von Fig. 19 sorgt ein zwischen Schenkeln 43i und 44i eines Verbindungsstücks 28i eingeschobener, die Schenkel aufweitender Steg 50i für eine Kontaktierung von Anschlussleiterstücken 11i und 12i.

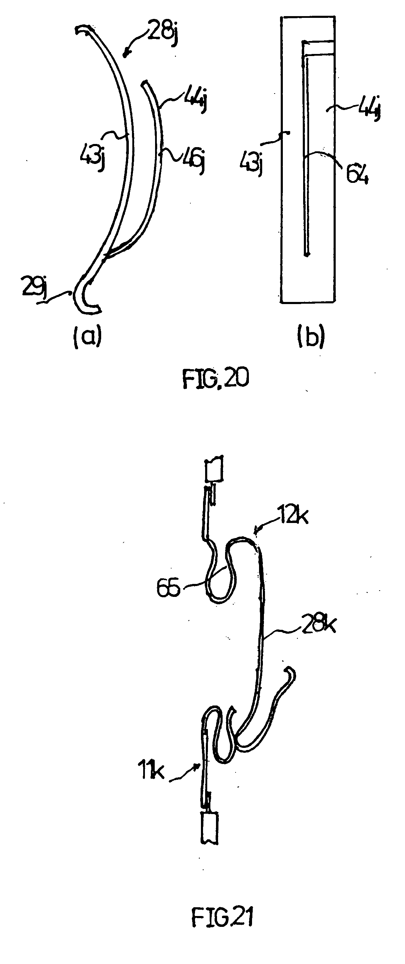

Fig. 20 zeigt ein Verbindungsstück 28j, bei dem zwei Schenkel 43j und 44j mit Kontaktabschnitten 29j und 46j durch einen in Fig. 20b sichtbaren, gewinkelten Einschnitt 64 gebildet sind.

Aus Fig. 21 gehen Anschlussleiterstücke 11k und 12k hervor. Ein tulpenblattförmiger Klemmabschnitt des Anschlussleiterstücks 12k weist einen Schenkel 65 auf, der unmittelbar in ein elastisch abbiegbares Verbindungsstück 28k übergeht.

## Patentansprüche

1. Anschlussvorrichtung (1) für einen Stromzähler (2), mit einer den Stromzähler (2) aufnehmenden Tragplatte (5), welche Durchgänge (10) für vom Stromzählergehäuse (8) vorstehende Anschlusskontaktstücke (9) aufweist, mit Anschlussleitern (11-17) auf der dem Stromzähler (2) abgewandten Seite der Tragplatte (5) für wenigstens eine Stromphase, welche durch Verschiebung des Stromzählers auf der Tragplatte jeweils mit einem der Anschlusskontaktstücke (9) elektrisch verbindbar oder davon lösbar sind, und mit einem die Anschlussleiter (11-17) bei Abkopplung des Stromzählers (2) von der Tragplatte (5) überbrückenden Verbindungsstück (28), das zur Herstellung oder/und Lösung der Überbrückungsverbindung über ein durch die Verschiebung des Stromzählers (2) auf der Tragplatte (5) betätigtes Schieberelement (33,35) bewegbar ist,
**dadurch gekennzeichnet,**
**dass** in der Überbrückungsstellung das Schieberelement (33,35) das Verbindungsstück (28) durch das Schieberelement (33,35) oder/und eine elastische Rückstellkraft des Verbindungsstücks (28) im Presskontakt mit wenigstens einem der Anschlussleiter (11-17) gehalten ist.

2. Anschlussvorrichtung nach Anspruch 1,
**dadurch gekennzeichnet,**
**dass** die durch das Schieberelement (33,35) oder/und die elastische Rückstellkraft erzeugte Presskraft quer zur Verschiebungsrichtung des Stromzählers (2) gerichtet ist.

3. Anschlussvorrichtung nach Anspruch 1 oder 2,
**dadurch gekennzeichnet,**
**dass** das Schieberelement (33,35) gegen das durch das Schieberelement bewegte Verbindungsstück (28) gleitend oder rollend unter Bewegung des Verbindungsstücks (28) quer zur Verschiebungsrichtung des Stromzählers (2) oder/und unter Drehung des Verbindungsstücks (28) anliegt.

4. Anschlussvorrichtung nach einem der Ansprüche 1 bis 4,
**dadurch gekennzeichnet,**
**dass** das Verbindungsstück (28) ständig mit einem der Leiterstücke (12,14,16) verbunden ist.

5. Anschlussvorrichtung nach Anspruch 4,
**dadurch gekennzeichnet,**
**dass** das Verbindungsstück als durch das Schieberelement (33,35) abbiegbare Zunge (28) einstückig mit einem der Leiterstücke (12,14,16) verbunden ist.

6. Anschlussvorrichtung nach einem der Ansprüche 1 bis 5,
**dadurch gekennzeichnet,**
**dass** das Verbindungsstück (28) als einarmiger Hebel mit einem Kontaktabschnitt (29) zwischen dem Drehpunkt und einem Angriffsabschnitt (30) für das Schieberelement (33,35) ausgebildet ist.

7. Anschlussvorrichtung nach einem der Ansprüche 1 bis 6,
**dadurch gekennzeichnet,**
**dass** das Schieberelement (33,35) in der Überbrückungsstellung des Verbindungsstücks (28) durch eine Haltenase (40) in einer Richtung parallel zur Tragplatte (5) abgestützt ist.

8. Anschlussvorrichtung nach einem der Ansprüche 1 bis 7,
**dadurch gekennzeichnet,**
**dass** die Anschlussleiter (11-17) jeweils eine Kontaktgabel (19) mit einander gegenüberliegenden Klemmschenkeln (20,21) aufweisen, zwischen denen jeweils ein Anschlusskontaktstück (9) des Stromzählers (2) einklemmbar ist.

9. Anschlussvorrichtung nach Anspruch 8,
**dadurch gekennzeichnet,**
**dass** in der Überbrückungsstellung der Kontaktabschnitt (29) des Verbindungsstücks (28) gegen einen der Klemmschenkel (20,21) der betreffenden Kontaktgabel (19) anliegt.

10. Anschlussvorrichtung nach einem der Ansprüche 1 bis 9,
**dadurch gekennzeichnet,**
**dass** das Schieberelement (33,35) eine zwischen der Tragplatte (5) und den Anschlussleitern (11-17) angeordnete Schieberplatte (33) mit zu den Anschlussleitern (11-17) vorstehenden Nasen (35) umfasst.

11. Anschlussvorrichtung nach Anspruch 10,
**dadurch gekennzeichnet,**
**dass** in der Schieberplatte (33) eine in eine Ausnehmung (37) in der Schieberplatte (33) ragende Zunge (39) gebildet ist, welche ein Hakenelement (36) aufweist, das eine Verschiebung der Schieberplatte (33) durch den Stromzähler (2) bei schrägem Aufsetzen des Stromzählers (2) auf die Tragplatte (5) verhindert, wobei die Zunge (39) durch ordnungsgemäßes Aufsetzen des Stromzählers aus der Verhakung durch das Hakenelement (36) lösbar ist.

12. Anschlussvorrichtung nach einem der Ansprüche 1 bis 11,
**dadurch gekennzeichnet,**
**dass** das Verbindungsstück (28h,28i) eine U-Form aufweist und in der Überbrückungsstellung die U-Schenkel (43h,43i;44h,44i) im Presskontakt mit den Anschlussleitern stehen.
